Europäisches Patentamt

European Patent Office

Office européen des brevets

(19)

(11) Publication number:  0 315 350
A1

## (12) EUROPEAN PATENT APPLICATION

(21) Application number: 88310001.8

(22) Date of filing: 25.10.88

(51) Int. Cl.⁴: H01L 21/322 , G02B 6/12 , G02F 1/01

(30) Priority: 02.11.87 US 115286

(43) Date of publication of application:
10.05.89 Bulletin 89/19

(84) Designated Contracting States:
DE ES FR GB

(71) Applicant: AMERICAN TELEPHONE AND
TELEGRAPH COMPANY
550 Madison Avenue
New York, NY 10022(US)

(72) Inventor: Dautartas, Mindaugas Fernand
2105 Wisteria Circle
Macungie Pennsylvania 18062(US)
Inventor: Martin, Edward Paul, Jr.
439 Greenwood Avenue
Bethlehem Pennsylvania 18017(US)
Inventor: Harrus, Alain Simon
205 E. Meade Street
Philadelphia Pennsylvania 19118(US)
Inventor: Stevie, Fred Anthony
4127 Clauser Road
Orefield Pennsylvania 18069(US)

(74) Representative: Johnston, Kenneth Graham et
al
AT&T (UK) LTD. AT&T Intellectual Property
Division 5 Mornington Road
Woodford Green Essex, IG8 OTU(GB)

(54) Low temperature intrinsic gettering techniques.

(57) Ionic drift in integrated devices is reduced by
the utilization of a gettering layer interposed between
the surface dielectric and the electrodes. The ma-
terial used to form this layer is capable of gettering
the mobile ions at a relatively low temperature
(<400°C).

EP 0 315 350 A1

# LOW TEMPERATURE INTRINSIC GETTERING TECHNIQUES

## Background of the Invention

This invention relates to a technique for achieving low temperature (<600° C) gettering of contaminants in integrated device structures, these structures including but not limited to, silicon-based multi-level metal layer devices, highspeed III-V devices, and integrated optic devices.

As the complexity of various integrated structures increases, it has become difficult, if not impossible, to utilize the conventional high temperature gettering techniques well-known in the art, one exemplary technique being disclosed in U.S. Patent 3,632,438 issued to H. G. Carlson et al on January 4, 1972.

In the realm of silicon integrated circuit technology, for example, multi-level metallization schemes are becoming more prevalent. This places an upper limit on the processing temperatures used after the formation of the first metal layer. Due to the problems of Hillock formation and contact resistance, the highest processing temperature subsequent to the formation of this first metallization cannot exceed 400° C. The dielectric isolation between this first metal layer and subsequent metal layers is deposited at temperatures consistent with this upper limit. However, there is no conventional technique for gettering impurities present in this layer at or below this temperature limit of 400° C.

Galium arsenide (GaAs) wafers grown by liquid phase epitaxy (LPE) processes exhibit poor intrinsic properties such as uniformity, purity and electron mobility. These wafers cannot withstand the high temperatures associated with conventional silicon gettering. Therefore, extrinsic gettering techniques (external mechanical damaging techniques) have been utilized to improve the device properties. One such exemplary prior art extrinsic gettering method for GaAs is disclosed in U.S. Patent 4,525,239 issued to F-C Wang on June 25, 1985. Although the disclosed method is capable of gettering the impurities, an intrinsic method of accomplishing the same result would be preferable, since the process of mechanically damaging wafers must be well-controlled and is inherently time-consuming.

In the rapidly maturing field of optical communications, integrated optical devices such as switches, beam splitters, couplers, etc., are finding increasing importance. These devices usually comprise a number of common components - an optically anisotropic crystal substrate (lithium niobate or lithium tantalate being common choices), waveguiding structures diffused into the surface of the substrate (titanium or tantalum metals, for example) and electrodes disposed over the surface of the substrate above the waveguides. A dielectric layer is used to insulate the substrate from the electrodes.

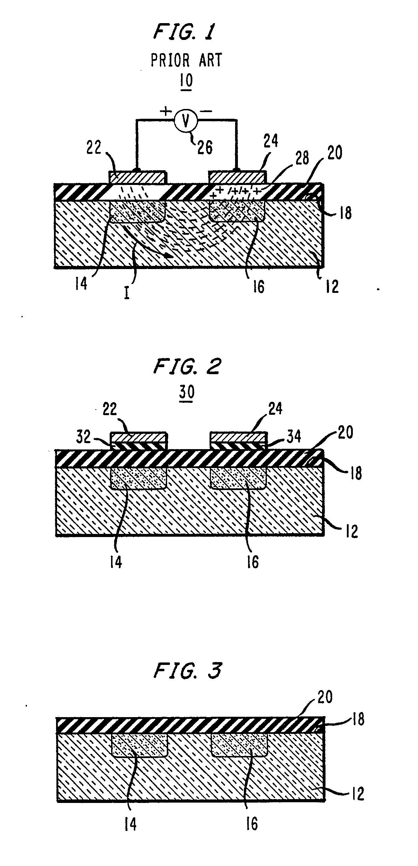

FIG. 1, which illustrates in cross-section a conventional prior art optical switch 10, is representative of the type of device structure described above. Switch 10 comprises an $LiNbO_3$ substrate 12 and a pair of titanium (Ti) waveguides 14,16 diffused into top major surface 18 of substrate 12. A dielectric layer 20 is disposed to cover top major surface 18, where layer 20 may comprise $SiO_2$. A pair of electrodes, 22,24, formed of aluminum, for example, are deposited to cover waveguides 14,16. In operation of switch 10, an optical signal I passing through the waveguides travels in the direction indicated in FIG. 1. It is well known that this optical signal may be "switched" from one waveguide to another by the application of an external voltage, since the voltage will result in the formation of an electric field in the waveguides and substrate, this electric field thus modifying the respective refractive indices of these regions. For example, an applied voltage 26 of given magnitude V will cause optical signal I traveling through waveguide 14 to "switch" to waveguide 16.

A problem with these prior art integrated optic devices is that they are subject to ionic drift which is capable of degrading the device performance. Ionic drift is a time-dependent phenomenon which results in the creation of an electric field $E_{ionic}$ which opposes the electric field $E_{applied}$ induced by the applied voltage. This is illustrated by the build-up of positive charge 28 under electrode 24 in FIG. 1. In conventional $LiNbO_3$ or $LiTaO_3$ devices, these positive charges are mobile Li ions from substrate 12 which travel along the electric field lines as shown. In general, these ions may be classified as alkali ions and include, among others, lithium, sodium, and potassium. To maintain the same state in switch 10 in the presence of $E_{ionic}$, therefore, an ever-increasing voltage is required to be applied between electrodes 22 and 24. Without some means of removing ionic charges 28, therefore, device performance limitations will be exceeded and the switch will fail.

In summary, therefore, a great need exists in the prior art for an intrinsic gettering technique which is functional at the relatively low temperature processing limits of many state-of-the-art devices.

## Summary of the Invention

The need remaining in the prior art is addressed by this invention which relates to a technique for reducing ionic drift in integrated devices by using a gettering layer between the device dielectric and electrode structure.

In accordance with the teachings of the present invention, the conventional process of forming integrated devices is altered to include the formation of a gettering layer, for example, phosphosilicate glass, before the final electrode structure is formed. The gettering layer is annealed at a temperature sufficient to trap the mobile ions without causing appreciable out-diffusion of other materials.

For use with silicon and III-V device structures, the gettering layer is formed as a relatively thin intermediate layer between first and second thick dielectric layers, the combination of these dielectric layers forming the insulation between the device and surface electrodes. The mobile ions remain trapped in this intermediate region, far removed from either active device areas or surface electrodes. The gettering material must be located at a distance removed from the electrodes, since multi-level metal structures use an undensified silicon dioxide dielectric, which if placed in contact with the gettering material would lead to corrosion of the electrodes.

With respect to integrated optical devices, a variation of this structure may be employed, since direct contact of the gettering material with the electrodes does not result in corrosion. In particular, the gettering layer is merely formed on top of the device dielectric and the electrodes deposited directly over the gettering layer at the desired locations. The electrodes are then used as a mask to remove all of the exposed gettering material, since the high conductivity of this layer would result in creating a short circuit between adjacent electrodes.

## Brief Description of the Drawing

Referring now to the drawings, where like numerals represent like parts in several views:

FIG. 1 illustrates a conventional integrated optical switch arrangement of the prior art;

FIG. 2 illustrates an improved optical switch including a gettering layer formed in accordance with the present invention;

FIGS. 3-6 illustrate various steps in the fabrication of the switch arrangement of FIG. 2;

FIG. 7 illustrates a mass spectroscopy analysis of a conventional integrated optic device, such as the switch of FIG. 1, illustrating in particular the location of Li ions;

FIG. 8 illustrates a secondary ion mass spectroscopy analysis of an integrated optical device formed in accordance with the present invention, illustrating the movement of the Li ions to the layer of gettering material;

FIG. 9 illustrates a simplified view of an exemplary prior art multi-level metal silicon integrated circuit structure; and

FIG. 10 illustrates a multi-level metal silicon integrated circuit including an intermediate gettering layer formed in accordance with the present invention.

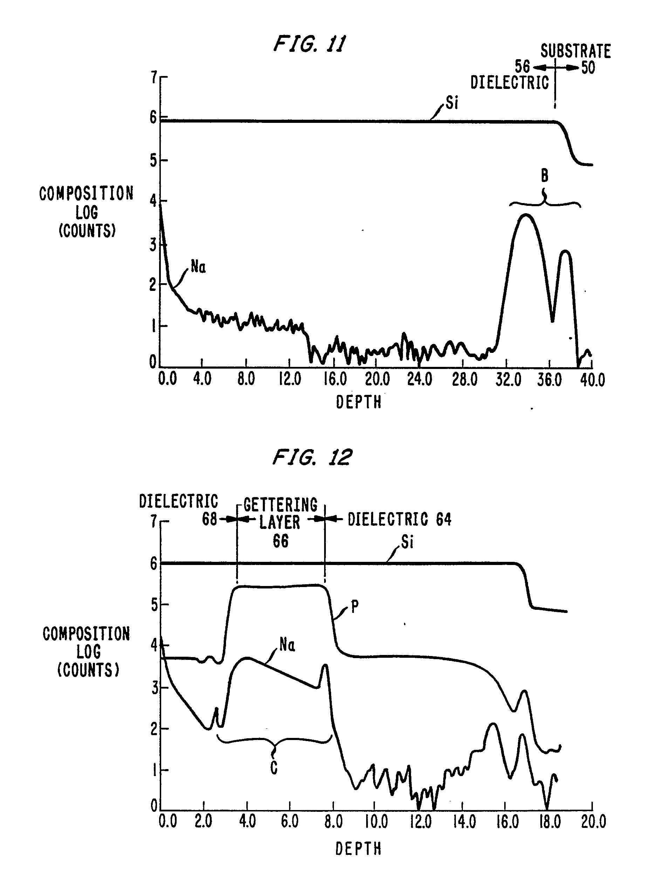

FIG. 11 illustrates a secondary ion mass spectroscopy analysis of a conventional multi-level silicon integrated circuit, illustrating in particular the presence of a significant concentration of sodium ions at the substrate/dielectric interface; and

FIG. 12 illustrates a secondary ion mass spectroscopy analysis of a multi-level metal silicon integrated circuit including the intermediate gettering layer formed in accordance with the present invention.

## Detailed Description

An integrated optic switch 30, formed using the techniques of the present invention is illustrated in FIG. 2. As with prior art switch 10, switch 30 of FIG. 2 comprises an anisotropic optical crystal substrate 12, a pair of waveguides 14, 16, a dielectric layer 20, and a pair of electrodes 22 and 24. In accordance with the present invention, however, switch 30 further comprises a layer of gettering material, in particular, phosphosilicate glass, interposed between dielectric 20 and electrodes 22,24. As stated above, this layer contains the mobile alkali ions, for example, Li ions, which travel from the substrate in the presence of an applied voltage. In the final device structure, this gettering layer takes the form of strips 32,34 located underneath electrodes 22 and 24, respectively. As stated above and discussed in greater detail hereinafter, the remainder of this gettering material must be removed (etched) to prevent the formation of a shunt between electrodes 22 and 24.

The process of fabricating switch 30 will now be described in greater detail. Referring to FIG. 3, switch 30 is illustrated at an early step in the fabrication process, where waveguides 14 and 16 have been formed in substrate 12, and dielectric layer 20 has been deposited to cover top major surface 18 of substrate 12. Waveguides 14 and 16 are usually formed in substrate 12 by the diffusion of an appropriate material, for example, titanium or tantalum, through top major surface 18 of substrate 12. U. S. Patent 4,284,663 issued to J. R. Carruthers et al on August 18, 1981, describes in detail this indiffusion process. Dielectric layer 20 is conventionally formed by depositing a silicon dioxide layer of an appropriate thickness, for example, in the range of 1500-3000 Å. In accordance with the properties of the material forming the optical substrate, this deposition should be carried out at a relatively low temperature, for example, less than 600° C. This is due to the fact, mentioned above, that $Li_2O$ has a tendency to diffuse out of the substrate at elevated temperatures and disadvantageously affect the final device performance. Silicon dioxide in the form of diacetoxyditertiarybutooxysilane (DADBS) has been found to be preferable material for forming this dielectric layer. A complete description of the process of depositing this material may be found in U. S. Patent 4,597,985 issued to E. A. Chandross et al on July 1, 1986.

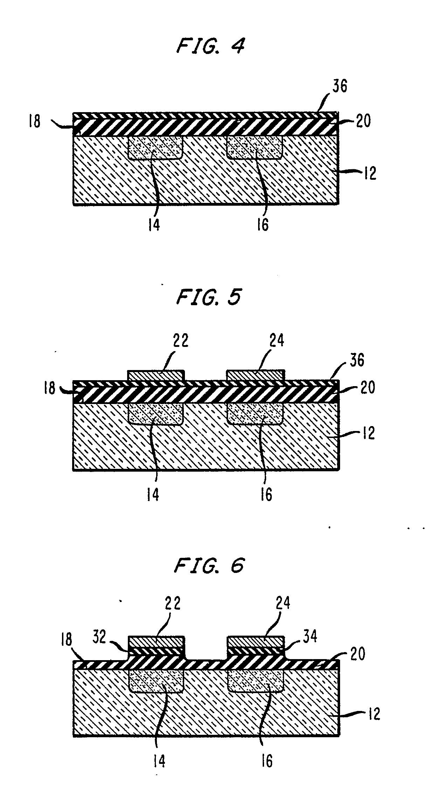

Subsequent to the formation of dielectric layer 20, a layer of gettering material 36 is formed to substantially cover dielectric 20, as illustrated in FIG. 4. As stated above, phosphosilicate glass (p-glass) may be used as this layer, since it may be deposited using a "spin-on" process, a low temperature deposition process. In accordance with the present invention, layer 36 is not required to comprise an appreciable thickness. For example, a layer of only 300 Å has been found to be sufficient to getter the majority of the mobile Li ions from the substrate. In fact, a gettering layer 36 having a thickness in the range of 2%- 10% of the thickness of deposited dielectric layer 20 has been found sufficient for present purposes. After the formation of p-glass layer 36, the device is annealed at a temperature sufficient to move the Li ions into layer 36. This is, of course, the critical step in the fabrication process of the present invention. The annealing must be performed at a temperature which activates the movement of the mobile ions from the substrate into the gettering layer without causing appreciable outdiffusion of other materials, for example, $Li_2O$. A temperature of approximately 500° C has been found to be sufficient for this purpose.

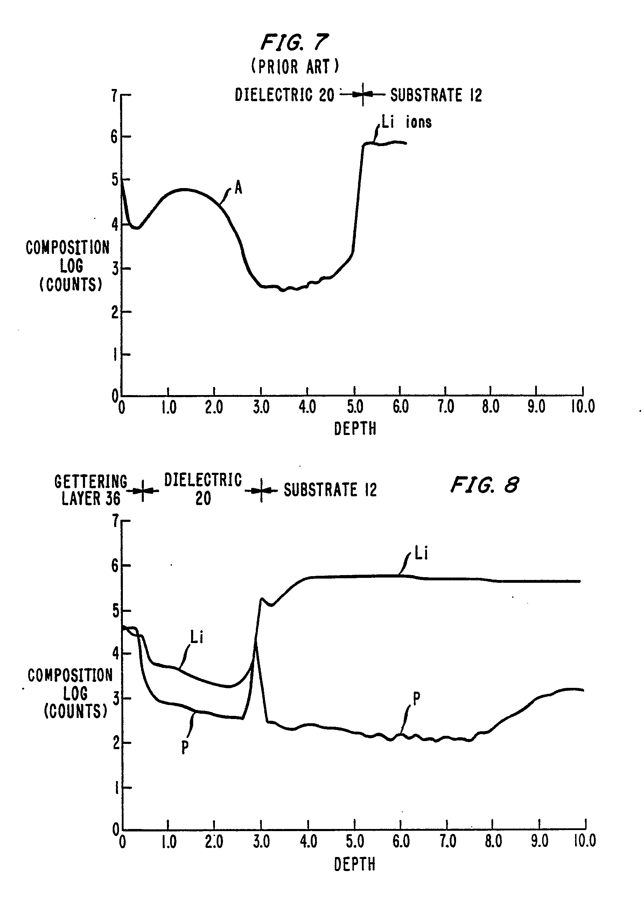

The next step in the fabrication process, involving the formation of the device electrodes, is essentially identical to that of the prior art. In particular, a metal layer (usually Al) is deposited to cover the dielectric, in this case the annealed gettering layer 36, and patterned to form the desired electrode structure. In this example layer 38 is patterned to form electrodes 22 and 24, as shown in FIG. 5. FIG. 6 illustrates the final device structure, where layer 36 has been etched to remove any exposed material. As stated above, this step is essential since the gettering layer is sufficiently conductive and polarized so as to create a shunt between electrodes 22 and 24. In theory, therefore, only that portion of layer 36 sufficient to "break" this shunt path need be removed. In actual practice, however, it is far easier to remove all exposed material, since electrodes 22 and 24 may be used as an etch mask and the material removed by treating the surface of the device with a buffered HF solution. This etching must continue for a period of time sufficient to remove the complete thickness of layer 36, since even a layer of only a few Å may be sufficiently conductive to create a shunt. In fact, it is preferred that the etching process be continued to remove a small amount of the underlying dielectric 20 which will also etch in a buffered HF solution, to insure that all of the gettered material has been removed. In fact, all of the underlying dielectric 20 may be removed without affecting device performance. Obviously, other methods of removing layer 36 may also be used in accordance with the present invention, so long as gettered layer 36 is completely removed and the shunt path between electrodes 22 and 24 is broken.

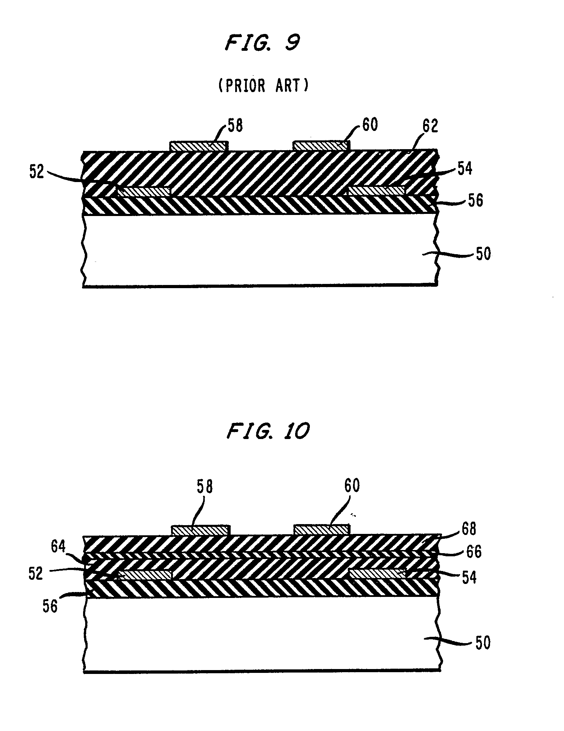

The modification of the composition of an integrated optical device formed using the gettering technique of the present invention is clearly illustrated by comparing FIGS. 7 and 8. FIG. 7 is a representation of the composition profile of a conventional prior art integrated optical device, such as switch 10 of FIG. 1. FIG. 8 is a representation of the composition profile of a device which has been gettered in accordance with the teachings of the invention, such as switch 30 of FIG. 2. Referring to both figures, the abscissa is defined as the depth of the associated device as measured along a vertical cut, the origin being defined as the top surface of the device. For FIG. 8, the origin is defined as the top surface of dielectric 20. With respect to FIG. 9, the origin is the top surface of gettering layer 36. The ordinate is scaled to indicate the relative amounts of various materials appearing at any particular depth within the device. As seen by reference to FIG. 7, a large "bump" of Li ions, indicated by the letter "A" in FIG. 7, exists in dielectric layer 20, near the surface. It is the presence of these ions, as discussed above, that results in degrading device performance through ionic drift.

FIG. 8, in comparison, illustrates a device including gettering layer 36, after this layer has been annealed. As shown, the Li ions present in the dielectric region defined by layers 20 and 36 reside mainly in gettering layer 36. Since this layer is removed to form the final device structure, the majority of Li ions will also be removed. Interestingly, the profile of the Li ions through dielectric 20 follows the phosphorous dopant profile introduced by gettering layer 36. It is to be noted that these particular composition profiles are shown as exemplary only, and are related to a set of particular processing parameters including, but not limited to, gettering layer thickness, phosphorous dopant concentration, anneal temperature and time interval, etc. Further, it is to be understood that the gettering technique of the present invention is applicable to any device structure which is subject to ionic drift and cannot be gettered using the conventional high temperature gettering techniques prevalent in the silicon technology. The majority of such devices are, in fact, optical devices formed on a substrate of an anisotropic optical crystal.

As described above, the low temperature gettering technique of the present invention is especially useful in silicon devices which incorporate two or more levels of metallic contacts. An exemplary multi-level metal structure as is known in the prior art is illustrated in FIG. 9. A silicon body 50 is shown for the sake of simplicity as only a substrate, however, it is this layer which contains the active device regions. Metal contacts 52,54 to selected areas (referred to as metal I) are insulated from the substrate by dielectric 56. In the prior art single level metal arrangements, these layers would form the final device structure, and a high temperature getter would be used extensively to remove defects from substrate 50. As circuit complexity increases, however, it is desirable to be able to achieve a larger number of metal contacts without utilizing a larger surface area. Therefore, a second set of metal contacts (58,60) (metal II) is disposed in the vertical direction above metal I and is separated from metal I by a thick insulating layer 62. In accordance with the multi-level metal technology, metal II must be deposited at a relatively low temperature (<400°C) so as not to create the problems (Hillock formation, etc.) described above It was discovered, however, as described above, that dielectric layer 62 becomes uncontrollably contaminated during various etchback and planarization operations. These contaminants thus introduce mobile metallic ions into the structure, subjecting the final device structure to the same ionic drift problem discussed above in association with the LiNbO₃ devices. A conventional high temperature getter would result in trapping these defects, but at the cost of destroying the metal I layer, clearly an undesirable result.

This ionic drift problem in multi-level metal silicon device structures is overcome with the low temperature getter technique of the present invention. The resultant structure is illustrated in FIG. 10. As seen, the low temperature dielectric 62 is replaced with a tri-level structure comprising a first undoped dielectric layer 64, a relatively thin phosphosilicate glass layer 66 and a second undoped dielectric layer 68. In particular, layer 64 may comprise an undoped glass (plasma-deposited TEOS, for example) deposited to a thickness of approximately 4000 Å. Layer 66 may then be deposited directly over layer 64 to a thickness of, for example, 1000-2000 Å. The remaining dielectric layer 68 is then deposited to a thickness to provide the total desired dielectric thickness. Unlike the LiNbO₃ structure, phosphosilicate glass layer 66 must remain removed from the electrode structure. This is due to the fact, as discussed above, that the low temperature oxide TEOS is undensified and the interaction of the p dopant in glass layer 66 with the metal electrode would result in corrosion of the electrodes.

It is obvious that the formation of the tri-level structure may be performed as a single operation, with the phosphorous doping occurring in-situ, that is, being added to the deposition of the dielectric at the correct time in sequence.

Since metal II electrodes must be sintered as a final fabrication step, this sintering process (performed at temperatures of approximately 375°C) will also anneal p-doped layer 66 to getter the mobile ions from the underlying dielectric.

## Claims

1. Method of fabricating an integrated device which includes intrinsically gettering the integrated device to reduce ionic draft the method including the steps of:

   a) forming the active regions (e.g., 14, 16) of the integrated device structure in a device substrate; and

   b) depositing a dielectric insulating layer (e.g., 20) over the device structure;

**CHARACTERIZED IN THAT**
the method further comprises the steps of:

   c) depositing a gettering layer (e.g., 36) of phosphosilicate glass over the dielectric insulating layer; and

   d) annealing said gettering layer at a temperature less than 600°C.

2. The method of claim 1 wherein the integrated device is an integrated optical device, wherein in performing step a), optical waveguides are formed in an optical substrate, and the method further comprises the following steps:

   e) forming an electrode structure over the waveguides formed in step a); and

   f) etching the device to remove at least all of the gettering layer deposited in step c).

3. The method of claim 2 wherein in performing step f), a portion of the underlying dielectric insulating is also etched.

4. The method of claim 2 wherein in performing step a), waveguides are diffused into the optical substrate.

5. The method of claim 1 wherein the integrated device is a multi-level silicon integrated device formed using a semiconductor substrate, wherein in performing step a), the following steps are performed:
diffusing active regions of a first and second conductivity type into the semiconductor substrate;
depositing a first metal electrode formation over preselected diffusions of the diffusing step; and in performing step c), the following steps are performed:
depositing a gettering layer of phosphosilicate glass over the dielectric insulating layer;
depositing a second dielectric insulating layer over the gettering layer;
depositing a second metal electrode formation over the second dielectric insulating layer.

6. The method of claim 5 wherein steps b) and c) are performed N times to form an N metal level silicon integrated device structure.

7. Method of forming an integrated optical device exhibiting reduced ionic drift, said device formed using a substrate of optically anisotropic material which includes mobile alkali ions known to cause ionic drift, said substrate material defined as having top and bottom major surfaces, the method comprising the steps of:
a) forming optical waveguiding structures in said substrate at the top major surface region;
b) depositing a dielectric layer over said top major surface of said substrate;
c) depositing a gettering layer over said dielectric layer formed in step b);
d) annealing said gettering layer at a temperature sufficient to trap mobile alkali ions, said temperature being less than the temperature known to cause outdiffusion of other materials from said substrate;
e) forming an electrode structure over said annealed gettering layer so as to substantially overlay the optical waveguiding structure formed in step a);
f) removing a sufficient portion of the exposed annealed gettering layer so as to remove any shunt path between electrodes formed in step e).

8. The method of claim 1 wherein in performing step c), phosphosilicate glass is used as the gettering layer material.

9. The method of claim 2 wherein in performing step c), the phosphosilicate glass is deposited using a spin-on technique.

10. The method of claim 1, wherein in performing step d), the gettering layer is annealed at a temperature in the range of $400^\circ$-$600^\circ$ C.

11. The method of claim 1, wherein in performing step f), the exposed annealed gettering layer is removed with an etchant that uses the electrode structure as an etch mask.

12. The method of claim 5, wherein in performing step f), the annealed gettering layer is etched with a buffered HF solution.

13. The method of claim 6, wherein in performing step f), the etching is performed for a time period sufficient to remove all of the exposed annealed gettering layer and a small portion of the dielectric layer.

14. The method of claim 1, wherein in performing step b), the dielectric is deposited to a thickness in the range of approximately 1500-3000 Å and in performing step c), the gettering layer is deposited to a thickness in the range of approximately 200-500 Å.

15. The method of claim 1, wherein in performing step a), a transition metal is diffused through the top major surface of the substrate to form the optical waveguiding structures.

16. The method of claim 9, wherein in performing step a), titanium is used to form the optical waveguiding structures.

17. The method of claim 1 wherein the optically anisotropic substrate is chosen from the group comprising $LiNbO_3$ and $LiTaO_3$.

*FIG. 1*

PRIOR ART

<u>10</u>

*FIG. 2*

<u>30</u>

*FIG. 3*

FIG. 4

FIG. 5

FIG. 6

## FIG. 7
### (PRIOR ART)

DIELECTRIC 20 ◄──┼──► SUBSTRATE 12

## FIG. 8

GETTERING LAYER 36 ◄──┼── DIELECTRIC 20 ──┼──► SUBSTRATE 12

## FIG. 9

(PRIOR ART)

## FIG. 10

EP 0 315 350 A1

FIG. 11

FIG. 12

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 224 712 (TEXAS INSTRUMENTS INC.) <br> * Figure 18; page 5, line 37 - page 6, line 21 * | 1,5 | H 01 L 21/322 <br> G 02 B 6/12 <br> G 02 F 1/01 |
| A | | 7,8,10, 11 | |
| X | US-A-3 465 209 (RCA CORP.) <br> * Figure 4; page 2, line 70 - page 3, line 51 * | 1 | |
| A | | 5,7,8, 10,14 | |
| A | EP-A-0 230 118 (BRITISH TELECOMMUNICATIONS PLC) <br> * Figure 1; page 2, line 44 - page 3, line 6 * | 2-4,7, 17 | |
| D,A | US-A-4 284 663 (BELL TELEPHONE LABORATORIES INC.) <br> * Abstract * | 2-4,7, 15-17 | |

TECHNICAL FIELDS SEARCHED (Int. Cl.4)

H 01 L
G 02 B

The present search report has been drawn up for all claims

| Place of search | Date of completion of the search | Examiner |
|---|---|---|
| THE HAGUE | 13-01-1989 | GELEBART J.F.M. |